(19) Europäisches Patentamt
European Patent Office
Office européen des brevets

(11) **EP 1 906 526 A2**

(12) **EUROPEAN PATENT APPLICATION**

(43) Date of publication:
**02.04.2008 Bulletin 2008/14**

(51) Int Cl.:
**H03H 17/02** *(2006.01)*   **H03H 17/04** *(2006.01)*

(21) Application number: **07380262.1**

(22) Date of filing: **26.09.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **26.09.2006 ES 200602433**

(71) Applicant: **Universidad Antonio de Nebrija**
**28240 Hoyo de Manzanares (Madrid) (ES)**

(72) Inventors:
• **Maestro de la Cuerda, Juan Antonio**
**28240 Hoyo de Manzanares**
**Madrid (ES)**
• **Reyes Moreno, Maria del Pilar**
**28240 Hoyo de Manzanares**
**Madrid (ES)**
• **Ruano Ramos, Oscar**
**28240 Hoyo de Manzanares**
**Madrid (ES)**
• **Reviriego Vasallo, Pedro**
**28240 Hoyo de Manzanares**
**Madrid (ES)**

(74) Representative: **Carpintero Lopez, Francisco et al**
**Herrero & Asociados, S.L.**
**Alcalá 35**
**28014 Madrid (ES)**

(54) **Method for detection and correction of errors due to radiation effects on moving average filters and moving average filters**

(57)    Method for the detection and correction of errors due to radiation effects on moving average filters, applicable in the field of microelectronics, based on the determination, in a first case scenario, of the degree of tolerance to filter (2) output errors and the type of input signal accepted by said filter (2), which gives to rise to, depending on whether said errors are tolerable or not and if said input signal undergoes inactivity periods, three methodologies and as many physical implementations with a non-redundant, recursive structure.

FIG. 2

**Description**

**OBJECT OF THE INVENTION**

The present invention relates to the field of microelectronics, applicable in the fields of communications, instrumentation, measurement, etc. and relates to a new method for protection for moving average filters against radiation effects and the filter used for such purpose.

Specifically, the object of the invention is to achieve a method for detection and correction of errors due to radiation in moving average filters, aimed at creating a new moving average filter capable of guaranteeing an optimal level of protection, in terms of complexity and cost, against radiation disturbances or effects.

**BACKGROUND OF THE INVENTION**

At present, radiation effects have become a major concern within the field of microelectronics, and even more in the operation of complex and expensive communications systems exposed to high doses of radiation, such as those used by the space industry.

Said effects not only have consequences from a microelectronic circuit functioning or response point of view, but also in terms of device design in radiation environments, which is conditioned by the existence of said effects.

One of the aforementioned radiation effects are the so-called Single Event Effects (SEEs), which cause undesired changes in bistable or combinational circuit logic element values.

Additionally, SEEs are classified in two types depending on whether the change in value due to radiation effects is produced in a storage element such as, for example, a bistable or memory cell, or in a combinational element such as, for example, a NAND gate or NOR gate.

Specifically, when SEEs are produced in storage elements they are referred to as Single Event Upsets (SEUs). When SEEs are produced in a combinational element they are referred to as Single Event Transients (SETs).

Different techniques have been applied to mitigate the effects of SEEs which, as previously mentioned, include both SEUs and SETs, such as, for example, those implemented at physical level, i.e. those consisting of modifying the size and structure of the devices to increase their resistance to said effects such as, for example, the use of shields, the use of larger transistors or with different polarization, etc.

However, such solutions have proved to be of little use both from an economical point of view and in terms of the space occupied by the devices, and particularly in sectors such as aerospace, where this is a determining factor.

For this reason, other techniques have been developed in an attempt to reduce radiation effects, such as the introduction of redundancy in circuit design in such a way that SEEs can be detected and corrected. The most frequently used redundancy technique is the so-called Triple Modular Redundancy (TMR) technique, which in order to avoid SEU effects, triples the storage elements and adds voting logic to correct errors.

On the other hand, the Functional Triple Modular Redundancy (FTMR) technique is used to combat SETs, which triples combinational logic.

However, although these techniques are generally valid for reducing or even eliminating radiation effects, they represent a high cost in terms of the space occupied by the circuits and power consumed thereof.

In order to avoid such problems, another option is to design specific protection techniques for each circuit such as, for example, in the case of moving average filters, by using their own structure to try to mitigate the aforementioned SEE effects.

As is well known, said moving average filters are represented by the equation

$$y[n] = \frac{1}{N} \sum_{i=0}^{N-1} x[n-i]$$

where x[n] = incoming signal, y[n] = outgoing signal and N = filter order.

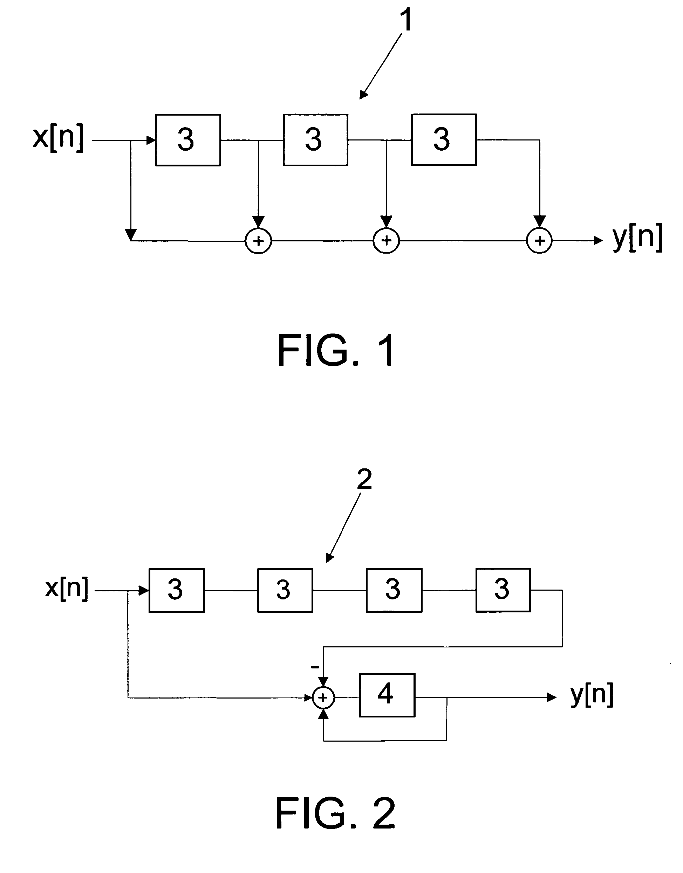

These filters, as it is also well known, may be implemented directly in the so-called Finite Impulse Response (FIR), one of the most frequently used structures of which is represented in Figure 1.

Another way of implementing said filters is recursively, also called Infinite Impulse Response (IIR) structure, of the type represented in Figure 2. Additionally, in this case the aforementioned general filter equation must be replaced by another, more intuitive, equation:

$$y[n] = y[n-1] + \frac{1}{N}(x[n] - x[n-N])$$

Based on the representation of the aforementioned FIR and IIR structures in figures 1 and 2, we can easily deduce that the former is more resistant to SEU effects, as these are temporary and last N-1 clock cycles at most, while these can produce errors in the outgoing signal of IIR structures that will persist until the filter is reset.

On the other hand, the IIR structure, despite being more vulnerable to SEU effects, has the advantage of being much simpler and therefore more efficient in terms of space, which lowers its cost.

In this way, an example of moving average filters with FIR structure, i.e. non-recursive, that do not use Triple Modular Redundancy or TMR can be found in US 6304133, which fundamentally consists of implementing moving average filters connected in cascade, such as the equivalent FIR filter that results from convoluting the response of all the moving average filters.

Schematically, the moving average filter implemented in US 6304133 proposes that the following is obtained, for example, for two four-order filters connected in cascade:

$$y[n] = 1/4^*(x[n]+x[n-1]+x[n-2]+x[n-3])$$

$$z[n] = 1/4^*(y[n]+y[n-1]+y[n-2]+y[n-3])$$

Due to which the output filter at the end of z[n] shall be the result of substituting the y[k] values with the corresponding values according to the first equation based on x[n], thereby obtaining:

$$z[n]=1/16^*(x[n]+2^*x[n-1]+3^*x[n-2]+4^*x[n-3]+3^*x[n-4]+2^*x[n-5]+x[n-6])$$

Accordingly, we can deduce that, in order to calculate z[n] sequentially, we must take x[0] and accumulate it in a log. In the next cycle we take x[1], multiply it by 2 and add it to the accumulator. In cycle 3 we take x[2], multiply it by 3 and add it to the accumulator, and so on.

This implementation, which avoids the IIR structure for the aforementioned vulnerability reasons, nevertheless has drawbacks inherent to its structure, such as a poor response in terms of speed, which can be easily be deduced from the previous example, wherein 7 clock cycles are required. Therefore, the higher the filter order number, the higher the number of clock cycles required to obtain the response.

Also, another drawback is its high degree of complexity, as it requires additional elements such as, evidently, the multipliers, in addition to a ROM because, given that the factor by which it is multiplied is different in each cycle, said factores must be stored in memory. This increased complexity also increases vulnerability collaterally due to the fact that, as the space occupied by the circuit is greater, the probabilities of being hit by radioactive particles also increase.

## DESCRIPTION OF THE INVENTION

The invention described below solves the aforementioned drawbacks, as it effectively protects the moving average filters against SEE effects by using a recursive or IIR structure, without using redundancy, i.e. without doubling, tripling, etc. neither its storage nor its combinational elements, which therefore increases efficiency in terms of space and responds to the aforementioned equation:

$$y[n] = y[n-1] + \frac{1}{N}(x[n] - x[n-N])$$

In this way, the methodology applied to effectively protect IIR filters against radiation effects consists of determining, in a first phase, the requirements of the system wherein said filter is going to be used or, in other words, the necessary degree of tolerance to SEUs or SETs.

On the other hand, once the type of response required in terms of SEE tolerance has been defined, we also need to determine the type of incoming signal required by the filter, both for the field of application to which said filters are directed and for the requirements or structure of the device wherein they are included.

This creates three possible scenarios that give rise to as many methodologies and implementations of the moving average filter of the present invention. More specifically, said scenarios would be the following:

a) Systems or devices wherein the filter is used to process a signal which presents inactivity periods during which there is no signal, only noise, in such a way that there are inactivity periods between pulses and that can also tolerate errors in the output filter, provided that these are transitory, such as, for example, communications systems that only transmit when there is data, or systems that only transmit voice when there is signal and if there is no signal they do not transmit, such as in the case of standard GSM technology.

b) Systems or devices wherein occasional errors are permitted in the output filter but where there are no inactivity periods, i.e. those wherein the filter is used to process a continuous signal without inactivity periods, such as in the case of, for example, many communications systems that continuously transmit a signal although data transmission is not required for the receptor to be ready and adapted to the channel conditions.

c) Systems or devices with protection requirements such that no SEU can be allowed to produce errors in the output filter such as, for example, audio systems wherein a SEU could produce audible noise.

In this way, once the type of scenario wherein the moving average filter is going to operate has been determined, both a methodology and different filter structure will be implemented, although always based on the IIR structure and without using Triple Modular Redundancy, which shall provide an adequate level of protection against radiation in each case in terms of complexity and effectiveness.

More specifically, the first case scenario, wherein errors in the output filter are tolerated provided that these are transitory, and wherein a signal with inactivity periods is processed, the moving average filter is provided with a logic unit through which an error detection and correction methodology can be adopted, consisting of the following steps:

- detect whether the incoming signal is undergoing an inactivity period;
- if such is the case, check whether the value of the accumulator responsible for storing the previous result y[n-1] is greater than the threshold value expected in that situation, which would indicate an error caused by a SEE; and
- if such is the case, reset both said accumulator and the N rows of the delay line x[n-1], x[n-2], ..., x[n-N] in order to correct the error.

In the second case scenario, wherein occasional errors are permitted but where there are no inactivity periods that may be used to reset the accumulator and the rows, the filter is structured in such a way that, taking advantage of the recursive implementation a decimated version of the filter, or decimated filter, is added, so as to allow the detection of errors caused by SEUs and therefore reset the filter to ensure that SEU effects are only temporary.

Specifically, said decimated filter is implemented by means of an accumulator which, rather than calculating the output y[n] for all n values, it only calculates it for yd[n]=y[D*n], i.e. for each D, D being the decimated factor. In this way, if for example, D = 10, said output y[n] would only be calculated for y[0], y[10], y[20], etc.

Therefore, in this case, SEE-induced error detection and correction comprises, each clock cycle, the following steps:

- couple the original filter parallel to the decimated filter (6) in order to calculate the output yd[n] for each D values of n, in the format yd[n]=y[D*n], being D=N=filter order;
- compare the output yd[n] of said decimated filter with the output of the original moving average filter for that instant and check whether the results differ; and
- if such is the case, reset both said accumulator and the N rows of the delay line x[n-1], x[n-2], ..., x[n-N] in order to correct the error.

Additionally, in order to consider the case in which the SEE could have been produced in the decimated filter rather than the original filter, which would lead to the undesired resetting of said original filter, the previously described steps would now be the following:

- couple the original filter parallel to the decimated filter (6) in order to calculate the output yd[n] for each D values of n, in the format yd[n]=y[D*n], being D=N=filter order;
- compare the output yd[n] of said decimated filter with the output of the original moving average filter for that instant and check whether the results differ;
- if such is the case, calculate or take the consecutive decimated filter output value yd[n], i.e. that of the following D sample;
- compare said consecutive decimated filter output value with the new original moving average filter output value for that new instant and check whether the results differ; and
- if such is the case, reset both said accumulator and the N rows of the delay line x[n-1], x[n-2], ..., x[n-N] in order to correct the error.

Finally, for the third case scenario, wherein no SEE-induced errors at filter output are permitted, advantage is taken of the fact that the rows that form the filter are connected in such a way that their values, x[n-1], x[n-2], etc., are propagated from one row to another without undergoing changes, i.e. they are transferred to the following row but without being modified, which can be used to calculate a bidimensional parity. Therefore, on one hand, parity bits are calculated for each row, which we shall refer to as vertical parity "Pv" and which is only updated upon input of the N rows of the delay line x[n-1], x[n-2], ..., x[n-N]. On the other hand, parity bits are calculated for each bit position in all the rows, which we shall refer to as horizontal parity "Ph", which is updated each clock cycle with the bit that enters the delay line x[n] and exits in that position x[n-N].

In this way, if an SEU-induced error appears in one of the bistables that form the rows, it can be detected through the corresponding vertical parity "Pv" and horizontal parity "Ph" bits, as an error will be detected in both simultaneously.

Therefore, in this case, SEU-induced error detection and correction comprises the following steps:

- calculate the vertical parity "Pv" bit for the input x[n] value for that instant;
- calculate the horizontal parity "Ph" bit for each bit position in each of the bistables that form the rows;
- compare the value of the "Pv" and "Ph" parity bits for that instant with the stored value and check whether both differ, which would give rise to two possible situations:

  - if both parity bits differ, the erroneous bit is identified as the crossing point of said "Pv" and Ph" parity bits and its value is inverted upon its propagation towards the following row of the delay line; and
  - on the contrary, if only one of said parity bits differs with respect to the stored value, no correction is made, as this fact means that SEU-induced error has ocurred in one of the "Ph" or "Pv" parity bits, in which case a correction of the bistable would be erroneous and would cause output errors.

On the other hand, it so happens that if the SEU-induced error occurs in one of the horizontal parity "Ph" bits, said error would be permanent, as the horizontal parity is recalculated each cycle based on the previous value, so that if said value is erroneous, the new calculated value will also be erroneous.

In order to detect and correct this situation, two error messages are generated, Errv and Errhm, by the vertical and horizontal parity bits respectively, so that said error is detected by the corresponding logic, by comparison of said parity bits if the error has occurred in the vertical parity "Pv" bit, in which case no action would be necessary, as it will either correct itself as it moves along the delay line towards the exit or else said error has occurred in the horizontal parity "Ph" bit, in which case its correction would be necessary.

In this way, the following, additional steps would be added to the previously described error detection and correction steps, with the object of considering this last possibility:

- compare, for each horizontal parity bit, the Errv and Errhm error messages;
- check whether Errv = 0 and Errhm = 1; and
- if such is the case, correct the horizontal parity bit by changing its value.

## DESCRIPTION OF DRAWINGS

The present description is complemented by a set of drawings aimed at further explaining the characteristics of the present invention, in accordance with a preferred embodiment thereof, wherein the following figures have been represented in an illustrative and unlimitative way.

Fig. 1   shows a schematic representation of a moving average filter with FIR structure;
Fig. 2   shows a schematic representation of a moving average filter with IIR or recursive structure;
Fig. 3   shows a schematic representation of the moving average filter bearing protection against the radiation to which the present invention relates, in the case wherein output errors are acceptable and a signal with inactivity periods is processed;
Fig. 4   shows a schematic representation of the moving average filter bearing protection against the radiation to which the present invention relates, in the case wherein output errors are acceptable and a signal without inactivity periods is processed;
Fig. 5   shows a schematic representation of the moving average filter bearing protection against the radiation to which the present invention relates, in the case wherein output errors are unacceptable;
Fig. 6   shows a schematic representation of the circuit used to detect and correct SEU-induced errors in one of the horizontal parity bits of the moving average filter shown in Figure 5.

## PREFERRED EMBODIMENT OF THE INVENTION

Figures 1 and 2 show a schematic structure of the moving average filters, both in their direct or FIR implementation (1) and their recursive or IIR implementation (2).

Generally speaking, said filters (1,2) consist of a determined number of storage units or rows (3) such as, for example, bistables (or flip-flops), which store input signal x[n] bit arrays, i.e. the values x[n-1], x[n-2], ..., x[n-N], etc., which tend to move towards the right along the rows towards the exit y[n], so that after each cycle the values change from x[n-1] to x[n-2], then to x[n-3], and so on until becoming x[n-N]. Additionally, shown in Figure 2, the filter (2) with recursive or IIR implementation has an accumulator (4) which is simply another row formed, for example, by bistables, responsible for storing the previous result y[n-1] required for recursive implementation.

Based on said well-known basic configuration of the IIR, or recursive implementation, filters (2), the present invention consists of the construction of moving average filters with protection against radiation or, more specifically, with protection against the effects of SEUs and SETs.

Based on said basic configuration, and after having applied the methodology of the invention, by means of which the filter requirements are defined in terms of type of signal to be processed and the degree of protection desired or, in other words, once output errors are acceptable, the moving average filter of the invention shall be defined.

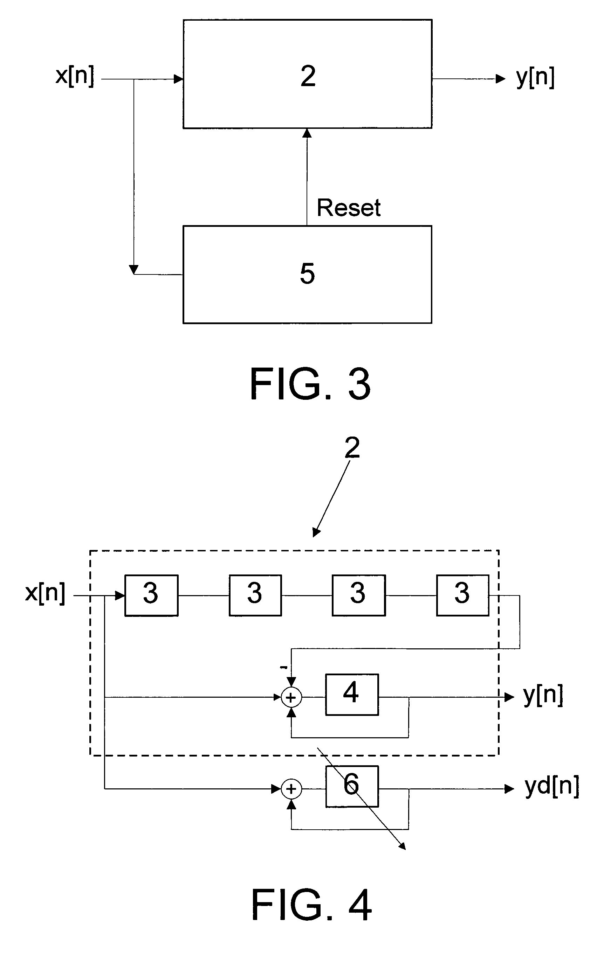

In this way, according to a first embodiment of the invention, indicated for those systems or devices wherein the filter is used to process a signal with inactivity periods during which there is no signal, the filter is structured as shown in Figure 3.

Specifically, and as shown in Figure 3, the moving average filter of the present invention consists of a moving average filter (2) with recursive or IIR implementation, which also has a logic unit (5) to detect the presence of inactivity periods in the incoming signal, moment in which said logic unit (5) checks whether the value of the accumulator (4) responsible for storing the previous result y[n-1] is greater than the threshold value, in which case a reset sign is sent both to said accumulator (4) and the rows (3).

Figure 4 shows a second embodiment of the invention, adequate for those cases wherein filter output errors are accepted but there are no inactivity periods.

In this case, and as shown in Figure 4, the moving average filter of the present invention consists of a filter (2) with recursive or IIR implementation to which a decimated filter (6) is coupled parallel to an accumulator, which calculates the decimated output yd[n], i.e. for each D, D being the decimated factor, which in this case adopts a value equal to N, i.e. to the number of filter rows, also called filter order.

In this way, the presence of a SEE will be detected when the accumulator (4) and decimated filter (6) outputs differ for the same instant n*D.

Finally, with a view to ruling out that the SEE has occurred in the decimated filter (6) itself rather than in the filter (2), a second comparison is made for the following consecutive value at said decimated filter (6) output.

In this way, if it is confirmed that outputs y[n] and yd[n] are different for two consecutive values, the presence of a SEE in the filter (2) is confirmed, due to which it shall be through, for example, the "clear" input of the bistables that form the rows (3) and accumulator (4).

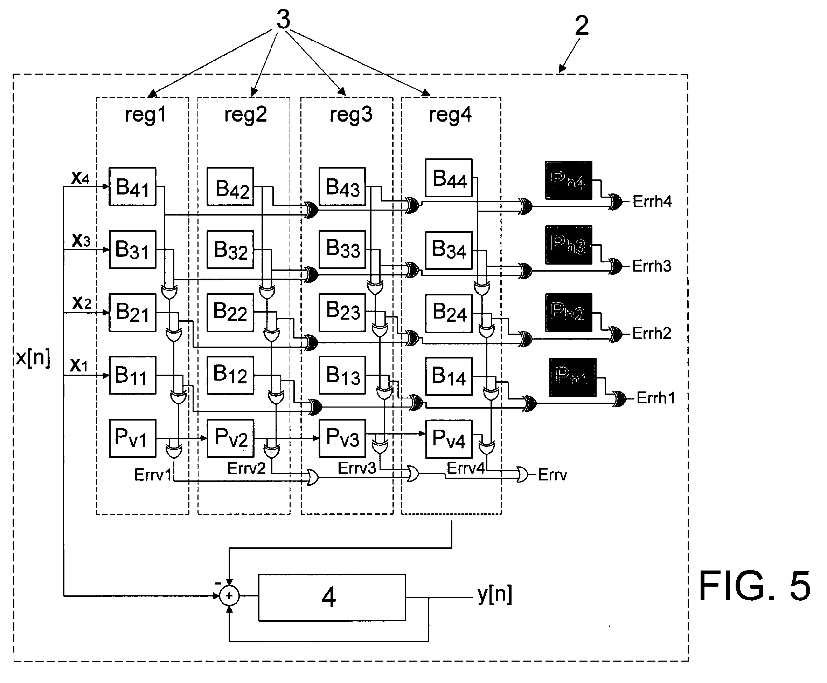

Finally, a third embodiment of the present invention is shown in Figure 5, which represents the structure of a moving average filter for those cases wherein no SEU-induced output errors are accepted.

As can be seen in Figure 5, a XNOR gate-based traditional parity calculus logic is coupled to the moving average filter in such a way as to obtain two-dimensional parity.

On one hand, said two-dimensional parity consists of parity bits for each row, called vertical parity "Pv" which, as shown in Figure 5, is broken down in the case of four rows (3), called "Row1", "Row2", "Row3" and "Row4" in the corresponding Pv1, Pv2, Pv3 and Pv4.

On the other hand, said two-dimensional parity consists of parity bits for each bit position in all the rows, called horizontal parity "Ph" which, as shown in Figure 5, is broken down in the case of an input x[n] of four bits called x1 [n], x2[n], x3[n] and x4[n] in the corresponding Ph1, Ph2, Ph3 and Ph4.

In this way, the parity bits, both vertical and horizontal, are recalculated each clock cycle, based on the B bistable values formed by each row (3), so that if a SEU occurs in any of these, a "Pv" and "Ph" will present a value different to that stored, thereby enabling the location of the erroneous bit at the crossing point of said "Pv" and "Ph" and its correction.

For example, if a SEU occurs in the $B_{23}$ bistable of the row, called "Row3", said SEU will be detected by parity bits Pv3 and Ph2, clearly and unequivocally defining the location of the SEU-induced error, said $B_{23}$ bistable thus being corrected upon its propagation to the following $B_{24}$ bistable.

Additionally, this structure is resistant to those SEUs that occur outside of the row (3) bistables, as if said SEU only occurs in one of the "Ph" or "Pv" parity bits, this would indicate that only one of these presents a difference, which would not lead to the erroneous resetting of any row.

On the other hand, the SEU could also occur in one of the horizontal parity Ph bits, due to which it could become permanent, as said horizontal parity is recalculated each cycle based on the previous value, so that if said value is erroneous the new value will also be erroneous.

In order to detect this possibility, on one hand, an "Errv" error message is generated which, as shown in Figure 5, will be generated whenever error occurs in one of the vertical parity bits Pv1, Pv2, Pv3 or Pv4, through the corresponding partial error messages Errv1, Errv2, Errv3 and Errv4 of each of the rows (3).

On the other hand, "Errhm" error messages are generated, where m represents the number of horizontal parity bits, which coincides with the number input signal bits, called, in this case, Errh1, Errh2, Errh3 and Errh4, which will be generated whenever an error occurs in any of the horizontal parity bits.

In this way, if for the example of embodiment shown in Figure 5, Errv = 0 and any "Errhm" sign = 1, then we will know that the SEU has occurred in the corresponding "Phm" horizontal parity bit and will be able to correct it.

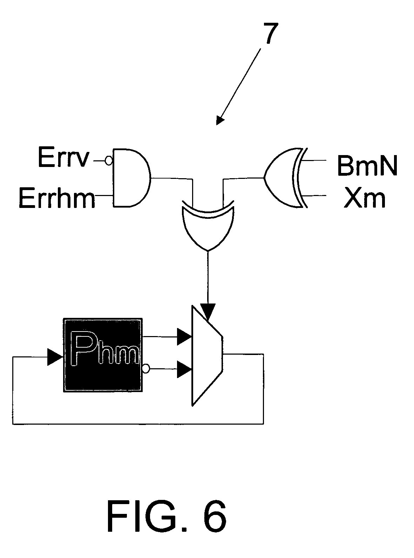

Said correction requires the implementation of a small logic circuit (7), such as that shown in Figure 6, where we can observe how the value of the Phm in which an error was detected is inverted as Phm = not(Phm).

More specifically, in said figure, being BmN = bit m of row N which abandons the delay line, and Xm = input bit m that will become Bm1 in the next cycle, Phm will change, i.e. it will take its denied value (which is erroneous), if BmN xor Xm xor = 1 (there is an error in Phm, as already explained), condition which is given by the denied Errv and Errhm error messages.

## Claims

1. Method for detection and correction of errors due to radiation effects on moving average filters, **characterized in that** the first step consists of

    - determining the degree of tolerance to filter output errors; and
    - determining the type of input signal that the filter will accept.

2. Method for detection and correction of errors, according to Claim 1, **characterized in that**, when transitory filter output (2) errors are acceptable and the input signal has inactivity periods, it consists of the following steps:

    a) through a logic unit (5), detect if the input signal is undergoing an inactivity period;
    b) if such is the case, check whether the value of the accumulator (4) responsible for storing the previous result y[n-1] is greater than the threshold value expected **in that** situation; and
    c) if such is the case, correct the error by resetting both said accumulator (4) and the rows (3) of the delay line.

3. Method for detection and correction of errors, according to Claim 1, **characterized in that**, when transitory filter output (2) errors are acceptable and the input signal does not have inactivity periods, it consists of the following steps:

    a) couple the filter (2) parallel to a decimated filter (6) that will calculate the output yd[n] for each D values of n, in the form of yd[n]=y[D*n], being D=N=filter order;
    b) compare the output yd[n] of said decimated filter (6) with that of original moving average filter (2) for the same instant and check whether they differ; and
    c) if such is the case, correct the error by resetting the rows (3) of the delay line and the accumulator (4).

4. Method for detection and correction of errors, according to Claim 3, **characterized in that**, in order to detect and correct the SEE-induced error when it occurs in the decimated filter (6) rather than in the filter (2), step c) above is replaced by the following steps:

    - c1) calculate the consecutive decimated filter (6) output value yd[n], i.e. the next D sample;
    - c2) compare said consecutive decimated filter (6) output value with that of the original moving average filter for this new instant and check whether they differ; and
    - c3) if such is the case, correct the error by resetting the rows (3) of the delay line and the accumulator (4).

5. Method for detection and correction of errors, according to Claim 1, **characterized in that**, when filter output errors are unacceptable, for each clock cycle, it consists of the following steps:

    - a) calculate the vertical parity "Pv" bit for the input value x[n] of each row (3) for that instant;
    - b) calculate the horizontal parity "Ph" bit for each bit position of each of the bistables formed by the rows (3);
    - c) compare the "Pv" and "Ph" parity bit values for that instant with the stored values and check whether they differ; and

    c1) if both parity bits are different, identify the erroneous bit at the crossing point of "Pv" and "Ph" and invert its value by propagating it towards the next row of the delay line; or
    c2) if only one of the parity bits is different, indicating that the SEU-induced error has not occurred in a bistable of a row (3), but rather in one of the parity bits, do not make any corrections.

6. Method for detection and correction of errors, according to Claim 5, **characterized in that**, in order to detect and correct the SEU-induced error when it occurs in one of the horizontal parity Ph bits, the following steps must be added to c2):

    - c2i) generate Errv and Errhm error messages based on the vertical and horizontal parity bits, respectively;
    - c2ii) compare the Errv and Errhm error messages for each horizontal parity Ph bit;
    - c2iii) check, in each case, whether Errv = 0 and Errhm = 1; and
    - c2iv) if such is the case, correct the horizontal parity bit by changing its value.

7. Moving average filter (2) **characterized in that** it has a recursive or IIR structure and because it has a means for the detection and correction of errors due to radiation effects without using Triple Modular Redundancy.

8. Moving average filter (2), according to Claim 7, **characterized in that** the means for the detection and correction of errors due to radiation effects includes a logic unit (5) capable of detecting input signal inactivity periods, checking whether the value of the result y[n-1] stored in the accumulator (4) is greater than the given threshold value, and resetting said accumulator (4) and the rows (3).

9. Moving average filter (2), according to Claim 7, **characterized in that** the means for the detection and correction of errors due to radiation effects includes a decimated filter (6) coupled parallel to the filter (2) that calculates the output yd[n] for each D value, D being the decimated factor of the decimated filter (6).

10. Moving average filter (2), according to Claim 9, **characterized in that** the D decimated factor of the decimated filter (6) is equal to the N number of rows of the filter (2).

11. Moving average filter (2), according to Claim 7, **characterized in that** the means for the detection and correction of errors due to radiation effects includes a vertical parity Pv calculus logic for the input of each of the N rows (3), and a horizontal parity Ph calculus logic for each bit position in all the rows (3).

12. Moving average filter (2), according to claims 7 and 11, **characterized in that** it has a means to detect whether the error caused by radiation effects has occurred in a vertical or horizontal parity bit.

13. Moving average filter (2), according to Claim 12, **characterized in that** the means to detect whether the error caused by radiation effects has occurred in a vertical or horizontal parity bit includes, in turn, a means to generate "Errv" error messages when said error occurs in one of the vertical parity bits of the rows (3); a means to generate "Errhm" error messages when the error occurs in one of the horizontal parity bits of the rows (3), and a logic circuit (7) that inverts the value of the horizontal parity bit wherein an error has been detected.

14. Moving average filter (2), according to Claim 13, **characterized in that** the value-inverting logic circuit (7) of the horizontal parity bit wherein an error has been detected is implemented by [(BmN XOR Xm) XOR ((NOT Errv) AND Errhm)], where BmN is the m bit of the N row that abandons the delay line, Xm is the input m bit that will become Bm1 in the next cycle and ((NOT Errv) AND Errhm) is the Errv=0 and Errhm=1 condition for an error to be detected in a horizontal parity bit.

15. Moving average filter (2), according to any of claims 11 to 14, **characterized in that** the horizontal and vertical parity calculus logic is based on XOR gates.

1

x[n] ⟶ [3] ⟶ [3] ⟶ [3] ⟶

⊕ ⟶ ⊕ ⟶ ⊕ ⟶ y[n]

# FIG. 1

2

x[n] ⟶ [3] ⟶ [3] ⟶ [3] ⟶ [3] ⟶

⊕ ⟶ [4] ⟶ y[n]

# FIG. 2

x[n] → | 2 | → y[n]

Reset

| 5 |

# FIG. 3

2

x[n] → | 3 | | 3 | | 3 | | 3 |

−

(+) → | 4 | → y[n]

(+) → | 6 | → yd[n]

# FIG. 4

FIG. 5

FIG. 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 6304133 B